Europäisches Patentamt

European Patent Office

Office européen des brevets

(11) Publication number: **0 068 844**
**B1**

## EUROPEAN PATENT SPECIFICATION

(45) Date of publication of patent specification: **08.10.86**

(51) Int. Cl.⁴: **H 01 L 27/02, H 01 L 21/31**

(21) Application number: **82303327.9**

(22) Date of filing: **25.06.82**

(54) A protective device for a semiconductor integrated circuit.

(30) Priority: **30.06.81 JP 100505/81**

(43) Date of publication of application:
**05.01.83 Bulletin 83/01**

(45) Publication of the grant of the patent:
**08.10.86 Bulletin 86/41**

(84) Designated Contracting States:
**DE FR GB**

(56) References cited:
PATENTS ABSTRACTS OF JAPAN, vol. 3, no.
10, 29th January 1979, page 93 E87

16th ANNUAL PROCEEDINGS ON RELIABILITY
PHYSICS, 18th-20th April 1978, pages 140-145,
San Diego, California (USA); I.S. BHATTI et al.:
"VMOS electrostatic protection"

IEEE TRANSACTIONS ON ELECTRON
DEVICES, vol. ED-27, no. 3, March 1980, pages
517-520, New York (USA); M. TANIMOTO et
al.: "A novel MOS PROM using a highly
resistive poly-Si resistor"

IBM TECHNICAL DISCLOSURE BULLETIN, vol.
22, no. 6, November 1979, page 2326, New
York (USA); N. EDWARDS: "Protect device for
LSI fet circuits"

(73) Proprietor: **FUJITSU LIMITED**
**1015, Kamikodanaka Nakahara-ku**
**Kawasaki-shi Kanagawa 211 (JP)**

(72) Inventor: **Shimada, Hiroshi**
**33-3, Kitashinjuku 4-chome**
**Shinjuku-ku Tokyo 160 (JP)**

(74) Representative: **Sunderland, James Harry et al**
**HASELTINE LAKE & CO Hazlitt House 28**
**Southampton Buildings Chancery Lane**
**London WC2A 1AT (GB)**

(56) References cited:
IBM TECHNICAL DISCLOSURE BULLETIN, vol.
13, no. 5, October 1970, page 1272-1273, New
York (USA); W. FISCHER et al.: "Resistor-thick
oxide FET gate protection device for thin oxide
FET"

## Description

This invention relates to a protective device for a semiconductor integrated circuit. More particularly, it relates to a device for protecting a semiconductor integrated circuit from a destruction phenomena which can be caused by a high voltage applied to the input terminal of the semiconductor integrated circuit.

Conventionally, at the input stage of a semiconductor integrated circuit, a protective MIS (metal-insulator-semiconductor) transistor is provided to protect the input transistor of internal circuitry of the IC (hereinafter referred to as the internal IC) from any high voltage input, for example caused by static electricity. The protective MIS transistor has a gate oxidation film thicker than that of transistors in the internal IC so that the protective MIS transistor operates only when a high voltage is applied and not when a normal operating voltage is applied. The diffusion region, that is, the drain region of the MIS transistor, is extended so as to provide a resistance region which also protects the internal IC from high voltage. At the end of the resistance region, the diffusion region is directly and electrically in contact with an input electrode wiring layer.

In such a conventional structure, however, since the diffusion region directly contacts the input electrode wiring layer, voltage tolerance at the input electrode is relatively low. That is, when a high voltage of, for example, 200 V is applied to the input electrode wiring layer, the electrode metal and the diffusion region contacting with the electrode metal generate excessive alloy which can easily penetrate through the diffusion region and short circuit the semiconductor substrate to the diffusion region. Thereafter, as a result, the internal IC cannot be driven even when a normal signal voltage is applied to the input electrode wiring layer because the input signal is directly conducted to the semiconductor substrate. Also, due to the presence of the resistance region in the diffusion region, the diffusion regin in the protective MOS transistor is large. Further, the junction capacitance between the contact portion of the diffusion region and the semiconductor substrate causes the input impedance of the internal IC to be large so that the operating speed of the semiconductor integrated circuit is detrimentally affected.

The article by W. Fischer et al in IBM Technical Disclosure Bulletin, Volume 13 No. 5, October 1970, discloses a protective device for a thin oxide FET in which a protective resistor, connected between the gate and drain of a protective transistor, is constituted by a diffusion region.

Japanese patent application JP—A—53 138 679 discloses a gate protecting device for a MOS type IC comprising a resistor of polycrystalline silicon inserted between an input terminal and a gate protecting diode.

The article by I. S. Bhatti et al in "16th annual proceedings on reliability physics", 18th—20th April 1978, discloses a VMOS protection device utilizing the special structure of VMOS diodes. The protection device consists of a polysilicon resistor connected to an nipn diode, followed by an implanted n+ diffusion which acts as a distributed RC network. It is disclosed that aluminium will alloy or spike through an n+ diffused junction at low voltage and energy levels.

The article by N. Edwards in IBM Technical Disclosure Bulletin, Volume 22, No. 6, November 1979, discloses the use of a 30Ω/□ polysilicon process to form a protective resistor in a protective device incorporating a lateral NPN transistor and a series resistor for LSI FET circuits. It is disclosed that a protective resistor made by this process would require less space than a diffused resistor.

According to the present invention there is provided a protective device for a semiconductor integrated circuit, comprising:

a protective input MIS transistor, having a diffusion region formed in a semiconductor substrate, for protecting said semiconductor integrated circuit from high input voltages;

a metal input electrode wiring layer;

a protective resistor connected between said diffusion region and said wiring layer; and

an insulating film arranged so as to be adjacent to said diffusion region;

characterised in that said insulating film is formed as an island in said diffusion region, and in that the protective device comprises

a first polysilicon layer having a relatively high impurity concentration, formed on said insulating film and electrically connected to said input electrode wiring layer, and

a second polysilicon layer, having a relatively low impurity concentration, lower than the impurity concentration of said first polysilicon layer, constituting said protective resistor, and electrically connecting said first polysilicon layer with said diffusion region.

An embodiment of the present invention can provide a protective device for a semiconductor integrated circuit in which the voltage which can be tolerated without destructive phenomena occurring between the input electrode wiring layer and the semiconductor substrate is increased.

An embodiment of the present invention can provide such a protective device as described above in which the protective input resistance region in the diffusion region is decreased in size.

An embodiment of the present invention can provide such a protective device as described above in which the junction capacitance between the diffusion region and the semiconductor substrate is decreased.

Reference is made, by way of example to the accompanying drawings, in which:—

Figure 1 is a circuit diagram illustrating a conventional protective circuit connected to an input stage of a semiconductor integrated circuit;

Figure 2 is a plan view illustrating main portions of a conventional device in which the circuit of Figure 1 is realised;

Figure 3 is an expanded cross-sectional view taken along line III—III' of Figure 2;

Figure 4 is a plan view illustrating main portions of a protective device according to an embodiment of the present invention;

Figure 5 is an enlarged plan view illustrating a part of the plan view of Figure 4; and

Figure 6 is a cross-sectional view taken along line VI—VI' of Figure 5.

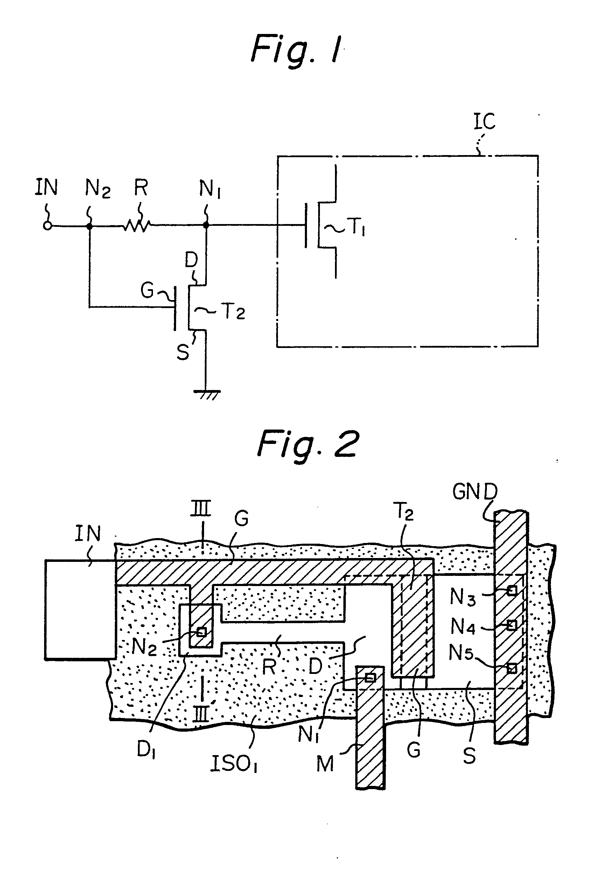

Before describing the embodiment of the invention, a conventional protective circuit and the problem involved therewith will first be described with reference to Figures 1 through 3.

Figure 1 is a circuit diagram illustrating a conventional protective circuit connected to an input stage of a semiconductor integrated circuit. In the figure, IC is a semiconductor integrated circuit, $T_1$ is a MOS transistor at the input stage of the semiconductor integrated circuit IC, R is a protective resistor, and $T_2$ is a protective MOS transistor. The gate of the input stage MOS transistor $T_1$, one end of the protective resistor R, and the drain D of the protective MOS transistor $T_2$ are connected at a first contact portion $N_1$. The other end of the protective resistor R and the gate of the protective MOS transistor $T_2$ are connected at a second contact portion $N_2$. The second contact portion $N_2$ is connected to an input terminal IN. The source S of the protective MOS transistor $T_2$ is grounded.

Figure 2 is a plan view illustrating a main portion of a conventional device realizing the circuit of Fig. 1. In Fig. 2, the protective MOS transistor $T_2$, the protective resistor R, and the input terminal IN are illustrated. S and D represent impurity diffusion regions which are the source and the drain of the protective MOS transistor $T_2$. A gate electrode metal layer G is arranged so as to cover a part of one side of the impurity diffusion region D and a part of one side of the inpurity diffusion region S. The metal layer G is connected to the input terminal IN. At a first contact portion $N_1$, the diffusion region D, that is, the drain of the protective transistor $T_2$, electrically contacts another metal layer M. The metal layer M is connected to the gate of the input stage transistor $T_1$ in the semiconductor integrated circuit IC (Fig. 1). The diffusion region S, that is, the source of the protective transistor $T_2$, electrically contacts a grounding electrode GND at contact portions $N_3$, $N_4$, and $N_5$. The diffusion region D is extended to form the protective resistor R. At an end portion $D_1$ of the protective resistor R, a second contact portion $N_2$ is provided. At the second contact portion $N_2$, the end portion $D_1$ of the resistor region R, that is, the other end of the protective resistor R, electrically contacts the gate electrode metal layer G. An insulation film $ISO_1$ is formed on the surface of the semiconductor substrate (not shown in Fig. 2) except for the diffusion regions D and S and an active region between the diffusion regions D and S. The insulation film $ISO_1$ insulates the protective

transistor $T_2$ and the protective resistor R from other elements.

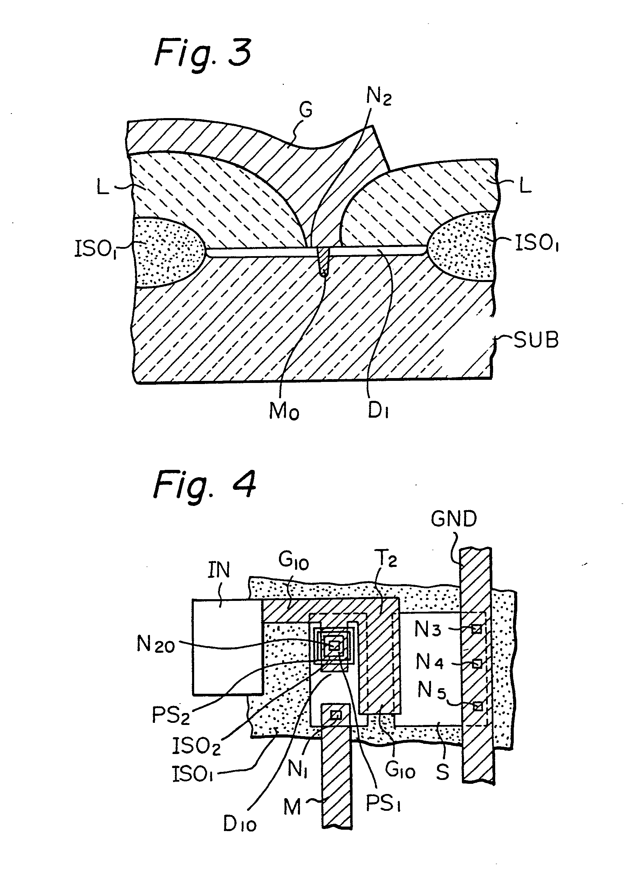

In the structure of the conventional device illustrated in Fig. 2, a problem exists in that the diffusion region D must be large since the diffusion region must be extended in order to incorporate the protective resistor R. Also, if a high voltage of, for example, 200 V or more is applied to the second contact portion $N_2$, the electrode metal destroys the diffusion region under the electrode metal and contacts with the semiconductor substrate under the diffusion region. This destruction phenomena will now be described with reference to Fig. 3.

Figure 3 is an expanded cross-sectional view taken along line III—III' of Fig. 2. In Fig. 3, the diffusion region $D_1$, that is, the end portion $D_1$ of the protective resistor R (Fig. 2), is formed at beneath the surface of a semiconductor substrate SUB. The type of conductivity of the semiconductor substrate SUB is opposite to that of the diffusion region $D_1$. The periphery of the diffusion region $D_1$ is insulated from other elements (not shown) by a first insulating film $ISO_1$. An oxidation film L for insulating between layers is formed so as to cover the diffusion region $D_1$, except for the contact portion $N_2$, and on the first insulating film $ISO_1$. On the insulating oxidation film L and on the contact portion $N_2$, a metal layer G is formed.

During normal operation, a sufficiently low voltage of, for example, 5 V is applied to the input terminal IN (see Figs. 1 and 2). In this case, the electrode metal does not destroy the diffusion region $D_1$ at the second contact portion $N_2$ and the input voltage is definitely applied through the metal layer G, the protective resistor R, the diffusion region D, and the metal layer M to the gate of the input stage MOS transistor $T_1$ (see Figs. 1 and 2). In contrast, if an extremely high voltage of, for example, 200 V or more is applied, due to static electricity, to the input terminal IN, a part $M_0$ of the electrode metal destroys the diffusion region $D_1$ and contacts the semiconductor substrate SUB. As a result, the electrode metal is short-circuited to the semiconductor substrate SUB so that the semiconductor integrated circuit IC (Fig. 1) cannot be driven. In addition, due to a PN junction capacitor between the diffusion region $D_1$ under the contact portion $N_2$ and the semiconductor substrate, the input carriers are stored in or discharged from the PN junction capacitor so that the operating speed of the semiconductor integrated circuit is deteriorated.

The present invention will now be described in detail with reference to Figs. 4 through 6, in which the above-mentioned destruction phenomena is prevented and the necessary space for the diffusion region of the protective resistor is decreased, as is the PN junction capacitance at the contact portion.

Figure 4 is a plan view illustrating a main portion of a protective device according to a first embodiment of the present invention. In Fig. 4, the same or similar portions are denoted by the same reference symbols as the reference symbols employed in Fig. 2.

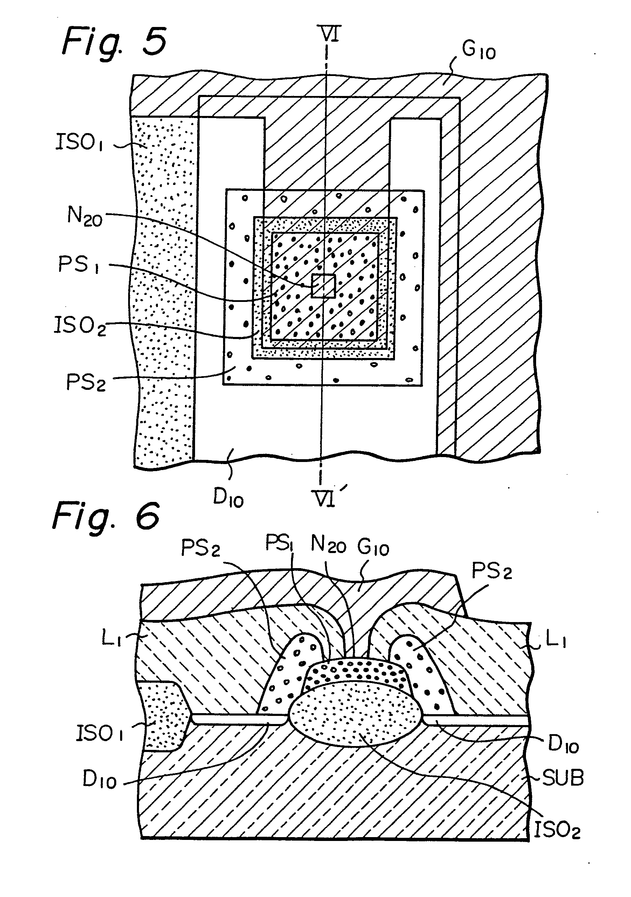

The difference between the plan view of Fig. 2 and the plan view of Fig. 4 is that in Fig. 2 the protective resistor R having the end portion $D_1$ is formed by extending the diffusion region D while in Fig. 4 the diffusion region $D_{10}$ is not extended so as to form a protective resistor having an end portion. Therefore, the length of the gate electrode metal layer $G_{10}$ for the protective transistor $T_2$ in Fig. 4 is greately reduced in comparison with the conventional structure shown in Fig. 2. In Fig. 4, $ISO_2$ represents a second insulating film formed in the diffusion region $D_{10}$. A contact portion $N_{20}$ is provided in the diffusion region $D_{10}$ so that the gate electrode metal layer $G_{10}$ electrically contacts through a first polysilicon layer $PS_1$ and a second polysilicon layer $PS_2$ the diffusion layer $D_{10}$. The diffusion region $D_{10}$ not only provides a space for the contact portion $N_{10}$ to make the gate electrode metal layer $G_{10}$ contact the diffusion region $D_{10}$ but also provides a space for the drain of the protective MOS transistor $T_2$. The structure of Fig. 4 will be described in more detail with reference to Figs. 5 and 6.

Figure 5 is an enlarged plan view illustrating the contact portion $N_{20}$ and the periphery of the contact portion $N_{20}$ of Fig. 4. Figure 6 is a cross-sectional view taken along line VI—VI' of Fig. 5. In Figs. 5 and 6, the second insulating film $ISO_2$ is provided in the portion of the diffusion region $D_{10}$ near the gate electrode metal layer $G_{10}$. Therefore, the second insulating film $ISO_2$ is surrounded by the diffusion region $D_{10}$ on all sides. In other words, the second insulating film $ISO_2$ is formed as an island in the diffusion region $D_{10}$. The center of the surface of the second insulating film $ISO_2$ substantially corresponds to the contact portion $N_2$. Thus, the central portion of the diffusion region $D_{10}$ is insulated from other layers by the second insulating film $ISO_2$. The periphery of the diffusion region $D_{10}$ is also insulated from other elements (not shown) by the first insulating film $ISO_1$. On the second insulating film $ISO_2$, a first polysilicon layer $PS_1$ having a high concentraton of inpurities is formed. A second polysilicon layer $PS_2$, having a low concentration of impurities lower than the concentration of the first polysilicon layer $PS_1$, is formed so as to electrically contact the first polysilicon layer $PS_1$ and the diffusion region $D_{10}$. That is, the second polysilicon layer $PS_2$ surrounds a part of the periphery of the second insulating layer $ISO_2$, a part of the periphery of the first polysilicon layer $PS_1$, and a part of the upper surface of the diffusion region D near the periphery of the second insulating film $ISO_2$. A contact portion $N_{20}$ is provided on the upper surface of the first polysilicon layer $PS_1$. An oxidation film $L_1$ for insulating between layers is also formed on the first polysilicon layer $PS_1$, except for the contact portion $N_{20}$, on the second polysilicon layer $PS_2$, on the remainder of the portion of the diffusion region $D_{10}$ not covered by the second polysilicon layer $PS_2$, and on the first insulating film $ISO_1$. On the oxidation film $L_1$ and on the contact portion $N_2$, the gate electrode metal layer $G_{10}$ is formed.

In the structure illustrated in Figs. 4, 5, and 6, even when a high voltage of up to 500 V is applied to the gate electrode metal layer $G_{10}$ connected to an input terminal, the electrode metal does not destroy the diffusion region $D_{10}$ and contact the semiconductor substrate because of the presence of the first polysilicon layer $PS_1$ and the second insulating film $ISO_2$. Also, because the concentration of impurities in the first polysilicon layer $PS_1$ is higher than the concentration of impurities in the second polysilicon layer $PS_2$, the electric resistance of the first polysilicon layer $PS_1$ is lower than the electric resistance of the second polysilicon layer $PS_2$. Therefore, a good electric contact is effected between the gate electrode metal layer $G_{10}$ and the first polysilicon layer $PS_1$, and the second polysilicon layer $PS_2$ acts as a protective resistor similar to the protective resistor R shown in Fig. 1. Therefore, during normal operation, an electrical path is formed between the gate electrode metal layer $G_{10}$ and the diffusion region $D_{10}$ through the first and the second polysilicon layers. Thus, extending the conventional diffusion region D so as to form the resistance region R as illustrated in Fig. 2 is not necessary according to the present invention. Further, under the contact portion $N_{20}$, there are only the first polysilicon layer $PS_1$ and the insulating film $ISO_2$. Therefore, almost no PN junction capacitance is present at the contact portion $N_{20}$. Accordingly, the input impedance for the semiconductor integrated circuit is decreased in comparison with the conventional device.

It will be apparent to those skilled in the art that the present invention is not restricted to the illustrated embodiments but that many other changes and modifications are possible without departing from the spirit of the present invention.

From the foregoing description, it will be apparent that, according to the present invention, at the contact portion of the input electrode wiring layer in a semiconductor integrated circuit, the electrode material is prevented from destroying the diffusion region even when a high voltage of up to 500 V is applied to the input terminal of the semiconductor integrated circuit. Also the protective resistor region is reduced in size in comparison with the conventional art. Further, the junction capacitance between the contact region and the diffusion region is reduced so that a low input impedance is obtained, resulting in high-speed operation of the semiconductor integrated circuit.

## Claims

1. A protective device for a semiconductor integrated circuit, comprising:
   a protective input MIS transistor ($T_2$), having a diffusion region ($D_{10}$) formed in a semiconductor substrate, for protecting said semiconductor integrated circuit from high input voltages;

a metal input electrode wiring layer ($G_{10}$);

a protective resistor ($PS_2$) connected between said diffusion region ($D_{10}$) and said wiring layer ($G_{10}$), and

an insulating film ($ISO_2$) arranged so as to be adjacent to said diffusion region ($D_{10}$);

characterised in that said insulating film ($ISO_2$) is formed as an island in said diffusion region ($D_{10}$), and in that the protective device comprises

a first polysilicon layer ($PS_1$) having a relatively high impurity concentration, formed on said insulating film ($ISO_2$) and electrically connected to said input electrode wiring layer ($G_{10}$); and

a second polysilicon layer ($PS_2$), having a relatively low impurity concentration, lower than the impurity concentration of said first polysilicon layer ($PS_1$), constituting said protective resistor, and electrically connecting said first polysilicon layer ($PS_1$) with said diffusion region ($D_{10}$).

2. A protective device as set forth in claim 1, wherein the first polysilicon layer ($PS_1$) comprises a contact portion ($N_{20}$) for electrically contacting with said input electrode wiring layer ($G_{10}$).

3. A protective device as set forth in claim 2, wherein the center of the surface of said insulating film ($ISO_2$) substantially corresponds to said contact portion ($N_{20}$).

4. A protective device as set forth in claim 1, 2, or 3, wherein said first polysilicon layer ($PS_1$ and said second polysilicon layer ($PS_2$) operatively provide an electrical path between said input electrode wiring layer ($G_{10}$) and said diffusion region ($D_{10}$).

5. A protective device as set forth in any preceding claim, wherein said protective device further comprises another insulating film ($ISO_1$), arranged in a region other than the active region of said protective transistor ($T_2$), for insulating said active region from other elements.

6. A protective device for a semiconductor integrated circuit, comprising

a protective input MIS transistor ($T_2$), having a diffusion region ($D_{10}$) formed in a semiconductor substrate, for protecting said semiconductor integrated circuit from high input voltages;

a metal input electrode wiring layer ($G_{10}$) formed of metal;

a protective resistor ($PS_2$) connected between said diffusion region ($D_{10}$) and said wiring layer ($G_{10}$), and

an insulating film ($ISO_2$) arranged so as to be adjacent to said diffusion region ($D_{10}$);

characterised in that said insulating film ($ISO_2$) is formed as an island of insulating film in said diffusion region, and in that the protective device comprises

a first polysilicon layer ($PS_1$) having a relatively high impurity concentration, formed on said island of insulating film ($ISO_2$) within the perimeter of the island and electrically connected to said input electrode wiring layer ($G_{10}$), and

a second polysilicon layer ($PS_2$) having a relatively low impurity concentration, lower than the impurity concentration of said first polysilicon layer ($PS_1$), constituting said protective resistor, said second polysilicon layer ($PS_2$) being formed over the edges of said island of insulating film ($ISO_2$) in contact with the diffusion region ($D_{10}$) at every portion thereof bordering said island of insulating film ($ISO_2$) and in contact with the first polysilicon layer ($PS_1$) all around the periphery of the latter layer.

**Patentansprüche**

1. Schutzvorrichtung für eine integrierte Halbleiterschaltung, mit:

einem schützenden Eingangs-MIS-Transistor ($T_2$), der einen Diffusionsbereich ($D_{10}$) hat, welcher in einem Halbleitersubstrat gebildet ist, zum Schutz der genannten integrierten Halbleiterschaltung vor hohen Eingangsspannungen;

einer metallenen Eingangselektrodenverdrahtungsschicht ($G_{10}$);

einem Schutzwiderstand ($PS_2$), der zwischen dem genannten Diffusionsbereich ($D_{10}$) und der genannten Verdrahtungsschicht ($G_{10}$) verbunden ist, und

einem isolierenden Film ($ISO_2$), der so angeordnet ist, um an den genannten Diffusionsbereich ($D_{10}$) anzugrenzen;

dadurch gekennzeichnet, daß der genannte isolierende Film ($ISO_2$) als eine Insel in dem genannten Diffusionsbereich ($D_{10}$) gebildet ist und daß die Schutzvorrichtung umfaßt

eine erste Polysiliziumschicht ($PS_1$), die eine relativ hohe Verunreinigungskonzentration hat, auf dem genannten isolierenden Film ($ISO_2$) gebildet ist und elektrisch mit der genannten Eingangselektrodenverdrahtungsschicht ($G_{10}$) verbunden ist; und

eine zweite Polysiliziumschicht ($PS_2$), die eine relativ niedrige Verunreinigungskonzentration, niedriger als die Verunreinigungskonzentration der genannten ersten Polysiliziumschicht ($PS_1$) hat, die den genannten Schutzwiderstand bildet und die genannte erste Polysiliziumschicht ($PS_1$) mit dem genannten Diffusionsbereich $D_{10}$) elektrisch verbindet.

2. Schutzvorrichtung nach Anspruch 1, bei welcher die erste Polysiliziumschicht ($PS_1$) einen Kontaktbereich ($N_{20}$) zur elektrischen Kontaktierung mit der genannten Eingangselektrodenverdrahtungsschicht ($G_{10}$) bildet.

3. Schutzvorrichtung nach Anspruch 2, bei welcher das Zentrum der Oberfläche des genannten isolierenden Films ($ISO_2$) im wesentlichen dem genannten Kontaktabschnitt ($N_{20}$) entspricht.

4. Schutzvorrichtung nach Anspruch 1, 2 oder 3, bei welcher die genannte erste Polysiliziumschicht ($PS_1$) und die genannte zweite Polysiliziumschicht ($PS_2$) im Betrieb einen elektrischen Weg zwischen der genannten Eingangselektrodenverdrahtungsschicht ($G_{10}$) und dem genannten Diffusionsbereich ($D_{10}$) bildet.

5. Schutzvorrichtung nach einem der vorhergehenden Ansprüche, bei welcher die genannte Schutzvorrichtung ferner einen anderen isolier-

enden Film (ISO₁) umfaßt, der in einem anderen Bereich als dem aktiven Bereich des genannten Schutztransistors (T₂) angeordnet ist, zur Isolierung des genannten aktiven Bereichs von anderen Elementen.

6. Schutzvorrichtung für eine integrierte Halbleiterschaltung, mit

einem schützenden Eingangs-MIS-Transistor (T₂), der einen Diffusionsbereich (D₁₀) hat, der in einem Halbleitersubstrat gebildet ist, zum Schutz der genannten integrierten Halbleiterschaltung vor hohen Eingangsspannungen;

einer metallenen Eingangselektrodenverdrahtungsschicht (G₁₀), die aus Metall gebildet ist;

einem Schutzwiderstand (PS₂), der zwischen dem genannten Diffusionsbereich (D₁₀) und der genannten Verdrahtungsschicht (G₁₀) angeschlossen ist, und

einem isolierenden Film (ISO₂), der so angeordnet ist, daß er an den genannten Diffusionsbereich (D₁₀) angrenzt;

dadurch gekennzeichnet, daß der genannte isolierende Film (ISO₂) als eine Insel auf dem isolierenden Film in dem genannten Diffusionsbereich gebildet ist, und daß die schützende Vorrichtung umfaßt

eine erste Polysiliziumschicht (PS₁) mit einer relativ hohen Verunreinigungskonzentration, die auf der genannten Insel aus dem isolierenden Film (ISO₂) innerhalb des Umfangs der Insel angeordnet und elektrisch mit der genannten Eingangselektrodenverdrahtungsschicht (G₁₀) verbunden ist, und

eine zweite Polysiliziumschicht (PS₂), die eine relativ niedrige Verunreinigungskonzentration, niedriger als die Verunreinigungskonzentration der genannten ersten Polysiliziumschicht (PS₁) hat und einen schützenden Widerstand bildet, wobei die genannte zweite Polysiliziumschicht (PS₂) über den Rändern der genannten Insel des isolierenden Films (ISO₂) in Kontakt mit dem genannten Diffusionsbereich (D₁₀) an jedem Abschnitt desselben, der an die Insel des isolierenden Films (ISO₂) angrenzt, und in Kontakt mit der ersten Polysiliziumschicht längs dem gesamten Umfang der letztgenannten Schicht gebildet ist.

**Revendications**

1. Dispositif de protection pour circuit intégré semiconducteur, comprenant:

— un transistor MIS d'entrée de protection (T₂), possédant une région de diffusion (D₁₀) formée dans un substrat semiconducteur, qui est destiné à protéger ledit circuit intégré semiconducteur vis à vis des hautes tensions d'entrée;

— une couche de câblage (G₁₀) pour électrode d'entrée, en métal:

— une résistance de protection (PS₂) connectée entre ladite région de diffusion (D₁₀) et ladite couche de câblage (G₁₀); et

— une pellicule isolante (ISO₂) disposée de façon à être adjacente à ladite région de diffusion (D₁₀);

caractérisé en ce que ladite pellicule isolante (ISO₂) se présente sous la forme d'un îlot dans ladite région de diffusion (D₁₀), et en ce que le dispositif de protection comprend:

— une première couche de silicium polycristallin (PS₁) possédant une concentration en impureté relativement élevée, qui est formée sur ladite pellicule isolante (ISO₂) et est électriquement connectée à ladite couche de câblage d'électrode d'entrée (G₁₀); et

— une deuxième couche de silicium polycristallin (PS₂) possédant une concentration en impureté relativement basse, plus basse que la concentration en impureté de ladite première couche de silicium polycristallin (PS₁), qui constitue ladite résistance protectrice et connecte électriquement ladite première couche de silicium polycristallin (PS₁) avec ladite région de diffusion (D₁₀).

2. Dispositif de protection selon la revendication 1, où la première couche de silicium polycristallin (PS₁) comprend une partie de contact (N₂₀) servant à établir un contact électrique avec ladite couche de câblage d'électrode d'entrée (G₁₀).

3. Dispositif de protection selon la revendication 2, où le centre de la surface de ladite pellicule isolante (ISO₂) correspond sensiblement à ladite partie de contact (N₂₀).

4. Dispositif de protection selon la revendication 1, 2 ou 3, où ladite première couche de silicium polycristallin (PS₁) et ladite deuxième couche de silicum polycristallin (PS₂) offrent fonctionnellement un trajet électrique entre ladite couche de câblage d'électrode d'entrée (G₁₀) et ladite région de diffusion (D₁₀).

5. Dispositif de protection selon l'une quelconque des revendications précédentes, où ledit dispositif de protection comprend en outre une autre pellicule isolante (ISO₁), disposée dans une région autre que la région active dudit transistor de protection (T₂), servant à isoler ladite région active vis à vis d'autres éléments.

6. Dispositif de protection pour circuit intégré semiconducteur, comprenant:

— un transistor MIS d'entrée de protection (T₂), possedant une région de diffusion (D₁₀) formée dans un substrat semiconducteur, qui sert à protéger ledit circuit intégré semiconducteur vis à vis des hautes tension d'entrée;

— une couche de câblage (G₁₀) pour électrode d'entrée, formée de métal;

— une résistance de protection (PS₂) connectée entre ladite région de diffusion (D₁₀) et ladite couche de câblage (G₁₀); et

— une pellicule isolante (ISO₂) disposée de façon à être adjacente à ladite région de diffusion (D₁₀);

caractérisé en ce que ladite pellicule isolante (ISO$_2$) se présente sous la forme d'un îlot de pellicule isolante dans ladite région de diffusion, et en ce que le dispositif de protection comprend:

— une première couche de silicium polycristallin (PS$_1$) ayant une concentration en impureté relativement élevée, qui est formée sur ledit îlot de pellicule isolante (ISO$_2$) à l'intérieur du périmètre de l'îlot et est électriquement connectée à ladite couche de câblage d'électrode d'entrée (G$_{10}$); et
— une deuxième couche de silicium polycristallin

(PS$_2$) possédant une concentration en impureté relativement basse, plus basse que la concentration en impureté de ladite première couche de silicium polycristallin (PS$_1$), qui constitue ladite ladite résistance protectrice, ladite deuxième couche de silicium polycristallin (PS$_2$) étant formée au-dessus des bords dudit îlot de pellicule isolante (ISO$_2$) en contact avec la région de diffusion (D$_{10}$) en toute partie de celle-ci bordant ledit îlot de pellicule isolante (ISO$_2$) et en contact avec la première couche de silicium polycristallin (PS$_1$) tout autour de la périphérie de cette dernière couche.

## Fig. 1

## Fig. 2

Fig. 3

Fig. 4

## Fig. 5

ISO₁

N₂₀

PS₁

ISO₂

PS₂

G₁₀

VI

VI'

D₁₀

## Fig. 6

PS₂   PS₁   N₂₀ G₁₀   PS₂

L₁   L₁

ISO₁   D₁₀

D₁₀   SUB

ISO₂